# EUROPEAN PATENT SPECIFICATION

(11) **EP 3 788 677 B1**
(45) Date of publication and mention of the grant of the patent: **10.07.2024**
(21) Application number: 18917499.8
(22) Date of filing: 01.05.2018
(51) Int. Cl.: H01Q 3/36, H01Q 9/04, H01Q 1/38, H01P 1/18, H05K 1/03, H01Q 21/06, H05K 1/02

(54) **LOW COST DIELECTRIC FOR ELECTRICAL TRANSMISSION AND ANTENNA USING SAME**
KOSTENGÜNSTIGES DIELEKTRIKUM FÜR ELEKTRISCHE ÜBERTRAGUNG UND ANTENNE MIT VERWENDUNG DAVON
DIÉLECTRIQUE À FAIBLE COÛT POUR UNE TRANSMISSION ÉLECTRIQUE ET ANTENNE UTILISANT CE DERNIER

(43) Date of publication of application: 10.03.2021
(73) Proprietor: Wafer LLC, Hanover, NH 03755 (US)
(72) Inventor: HAZIZA, Dedi, David, 2623174 Kiryat Motzkin (IL)
(74) Representative: Zimmermann & Partner Patentanwälte mbB
(86) International application number: PCT/US2018/030529
(87) International publication number: WO 2019/212542

(56) References cited:
- US-A- 4 783 666
- US-A1- 2002 175 669
- US-A1- 2010 060 535
- US-A1- 2010 060 535
- US-A1- 2010 231 482
- US-A1- 2012 276 311
- US-A1- 2018 062 266
- US-A1- 2018 062 272
- YUKA HASEGAWA ET AL: "Complex Permittivity Spectra of Various Insulating Polymers at Ultrawide-Band Frequencies", ELECTRICAL ENGINEERING IN JAPAN, vol. 198, no. 3, 1 February 2015 (2015-02-01), US, pages 11 - 18, XP055559666, ISSN: 0424-7760, DOI: 10.1002/eej.22925
- FILIPPO COSTA ET AL: "Material characterization for green chipless RFID report", 1 January 2016 (2016-01-01), pages 1 - 28, XP055559712, Retrieved from the Internet <URL:http://www.emergent-rise.eu/wp-content/uploads/2016/01/D2.4_Material-characterization-for-green-chipless-RFID.pdf> [retrieved on 20190220]
- SHARMA, V ET AL.: "Dual Band Circularly Polarized Modified Rectangular Patch Antenna for Wireless Communication", RADIOENGINEERING, vol. 23, no. 1, 1 April 2014 (2014-04-01), pages 195 - 202, XP055649131

## Description

### BACKGROUND

### 1. Field

This disclosure relates generally to the field of dielectric materials, used for insulating electrical conductors. The disclosed dielectric is particularly suitable for RF transmission lines, such as lines used for conducting RF signals for antennas.

### 2. Related Art

Common methods of conducting electromagnetic energy between locations are to use a circuit board with microstrip printed technology or using a metallic wave-guide. The advantage of a circuit board over a waveguide is that it can be produced in higher volumes and is flat. The disadvantage is the loss which is proportional to the distance the high frequency electronic signal travels. The advantage of a metallic wave-guide is that it operates with lower losses, but the disadvantage is that it is neither as thin as a circuit board nor as cost effective.

Some circuit board substrates are designed to have low propagation losses. The typical low loss substrate is a mixture of Teflon and glass. However, these Circuit Boards are more expensive because of the process of pressing the Teflon and glass flat, which requires tremendous pressure.

One problem with many low loss materials like Polytetrafluoroethylene, (commonly called Teflon^{®}), is that the thermal expansion and contraction rates for these materials is very different than that for the conductive metals, which they would otherwise be bonded to. For example, if a copper line is formed on Teflon, the Teflon will expand with temperature at a different rate than the copper, and therefore de-laminate the copper. The current art for dealing with this expansion problem is to load the Teflon material with glass to reduce its coefficient of thermal expansion, along with substantial other processes.

Another problem with many low loss materials like Teflon is that they have low surface energy, making it difficult to bond to a conductive circuit. In many instances, glues, or other adhesives are used and these materials have negative RF propagation factors.

A further disadvantage of Teflon is its high cost. In many modem applications the entire transmission circuitry needs to be of very low cost, which makes Teflon prohibitive.

Rohacell^{®} is a polymethacrylimide (PMI) based structural foam, marketed by Evonik Röhm GmbH, of Darmstadt, Germany. Rohacell has a relatively low dielectric constant, εᵣ, of about 1.046 to 1.093, depending on the particular formulation. Foam, such as Rohacell, has been used as dielectric in RF systems, as exemplified in U.S. Publication 2015/0276459, titled: Foam Filled Dielectric Rod Antenna.
US 2018/062266 A1 relates to a multi-layer software controlled antenna. A radiating patch is provided over a variable dielectric constant (VDC) plate. Variable DC potential is applied across the VDC plate to control the effective dielectric constant at various locations of the VDC plate. RF signal is coupled between a feed patch and a delay line, and the delay line couples the RF signal to the radiating patch. The radiating patch, VDC plate, delay line, and feed patch are each provided at a different layer of the antenna, so as to decouple the RF and DC signal paths. A controller executes a software program to thereby control the variable DC potential applied across the VDC plate, thereby controlling the operational characteristics of the antenna.
US 2010/060535 A1 relates to a microstrip patch antenna for mobile satellite communications comprising a first electrically conducting ground plane having at least one opening, at least one patch radiating element, at least one first dielectric layer, disposed between the first electrically conducting ground plane and the patch radiating element and more particularly between the at least one opening and the patch radiating element, at least one feed line for providing signal energy in a contactless manner to or from the patch radiating element through the opening and a second dielectric layer disposed between the feed line and the first electrically conducting ground plane wherein the antenna further comprises a second ground plane and a third dielectric layer disposed between the second ground plane and the feed line.

Accordingly, a need exists in the art for improved transmission vehicles for electromagnetic energy, which can be used, e.g., in antennas used for wireless communication.

### SUMMARY OF THE INVENTION

Disclosed embodiments provide a flat and low cost dielectric material. In disclosed examples the embodiments are applied to an antenna, but it could be applied to other devices which require high frequency electronic transmission, such as microwaves, radars, LIDAR, etc.

In the disclosed embodiments electrical conductors are separated by a dielectric material. The disclosed dielectric material may be used a replacement to Teflon^{®} for any application that currently uses Teflon. While Teflon possesses high performance characteristics, it is of relatively high cost. The disclosed embodiments can provide comparable performance as Teflon, but at a much lower cost.

In general aspects, the dielectric plate is made of a sandwich of at least two plates, one having high dielectric constant, such as glass, and another having dielectric constant as close as possible to that of air. A good example for glass is Vycor^{®} glass, while a good example for material having dielectric constant close to air is foam, such as structural foam, e.g., Rohacell^{®}. The foam should have dielectric constant of from 1.0 to 1.1

In an embodiment, an antenna as defined in claim 1 is provided.

The antenna may further comprise conductive electrodes abutting the VDC layer. At least one of: the insulating spacer, the dielectric plate, and the bottom insulating plate, may comprise a foam plate sandwiched between two glass plates or a foam plate sandwiched between two PET plates. The antenna may further comprise at least one conductive via connecting each one of the delay lines to a corresponding radiating patch. The ground plane can comprise at least one window, each aligned below a corresponding one of the radiating patches.

### BRIEF DESCRIPTION OF THE DRAWINGS

Other aspects and features of the invention would be apparent from the detailed description, which is made with reference to the following drawings. It should be appreciated that the detailed description and the drawings provides various non-limiting examples of various embodiments of the invention, which is defined by the appended claims.

The accompanying drawings, which are incorporated in and constitute a part of this specification, exemplify the embodiments of the present invention and, together with the description, serve to explain and illustrate principles of the invention. The drawings are intended to illustrate major features of the exemplary embodiments in a diagrammatic manner. The drawings are not intended to depict every feature of actual embodiments nor relative dimensions of the depicted elements, and are not drawn to scale.
Figure 1 is a cross-section of a prior art structure utilizing dielectric such as Teflon.
Figure 2 illustrates an embodiment of the dielectric for a transmission apparatus.
Figure 3 illustrates yet another embodiment of the transmission apparatus.
Figures 4A and 4B illustrate an embodiment for a software controlled antenna utilizing the disclosed dielectric sandwich.
Figure 5 illustrates a non-claimed embodiment for a non -radiating electronic device utilizing the disclosed dielectric sandwich.
Figure 6 illustrates a variant embodiment for an RF transmission conduit.

### DETALIED DESCRIPTION

Embodiments of the inventive dielectric sandwich will now be described with reference to the drawings. Different embodiments may be used for different applications or to achieve different benefits. Depending on the outcome sought to be achieved, different features disclosed herein may be utilized partially or to their fullest, alone or in combination with other features, balancing advantages with requirements and constraints. Therefore, certain benefits will be highlighted with reference to different embodiments, but are not limited to the disclosed embodiments.

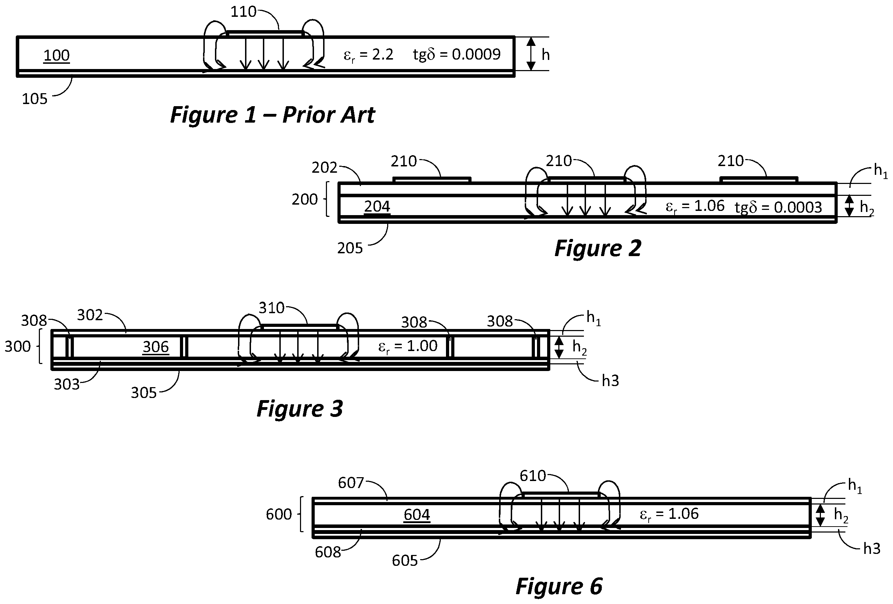

Figure 1 illustrates a cross-section of a prior art device that utilizes Teflon as the dielectric material 100. In this example, the dielectric constant of the Teflon is εᵣ = 2.2, while its loss factor (loss tangent - Ohmic losses) is tgδ = 0.0009. A ground conductor 105 is provided on the bottom of the dielectric 100, and a conducting and/or radiating electrode 110, such as a microstrip, is provided on top of the dielectric 100. The thickness of the dielectric is indicated as h.

The open-head arrows in Figure 1 illustrate the resulting field. As illustrated in Figure 1, part of the field travels only through the dielectric material, but some part of the field travels through both air and the dielectric material. Therefore, the effective dielectric constant is some average of the dielectric constant of the air and the dielectric constant of the Teflon (or other dielectric material used). The effective dielectric constant correlates to the square root of the product of the two dielectric constants, weighted by the effective volume. Since in the drawing of Figure 1 the dielectric constant of air is 1, the effective dielectric constant of the structure of Figure 1 equals that of the Teflon.

Figure 2 illustrates a general embodiment utilizing the innovative dielectric arrangement. In the embodiment of Figure 2, the dielectric sandwich 200 is made up of two materials: a plate 202 having high dielectric constant, e.g., Polytetrafluoroethylene, Polyethylene terephthalate (PET), glass fiber impregnated Polypropylene, or glass plate, and a plate of material having dielectric constant close to that of air, for example a structural foam that is mostly air, like, e.g., Rohacell 204. The ratio of the thicknesses of the two plates, h1/h2, is calculated to achieve the desired effective dielectric constant. For example, in the embodiment of Figure 2, a Vycor^{®} glass may be used. Vycor glass is a high silica glass marketed by Corning, and has a very low thermal coefficient of expansion. Depending on the formula used for fabrication, Vycor glass can have a dielectric constant of 3.8-4.4, with loss factor of 0.0003. The plate 204, made of Rohacell, has a dielectric constant of about 1.06 and loss factor of 0.0003. Thus, in this example, when making the thicknesses of both plates the same, i.e., h1/h2 = 1, the effective dielectric constant is εᵣ = 2.159, while the effective loss factor (serially additive) is tgδ = 0.0009.

From the example of Figure 2, it can be seen that disclosed embodiments provide a dielectric consisting of multiple layers of insulating materials contiguous with each other, thereby creating a low loss dielectric that may be tailored to have an effective dielectric similar to Teflon. The top layer in one example is made of a plate of glass. In Figure 2 an array of three radiating elements 210 are shown, although for clarity the field lines of only one radiating element 210 are shown.

Figure 3 illustrates a cross-section of another embodiment utilizing a multiple layers dielectric approach. The dielectric sandwich 300 of the embodiment of Figure 3 is made up of three layers: a first glass plate 302, a second glass plate 303, and a space 306 that is filled with air. The plates 302 and 303 are held apart with exact separation h2 using the spacers 308. The ground plate is formed on the bottom face of glass 303, while the transmission line or radiating electrode are formed on the top surface of glass 302. The thicknesses, h1 and h3, of glass plate 302 and glass plate 303, respectively, are calculated to provide the desired effective dielectric constant, once calculated with the layer 306 of air in between. In this case, if one makes h1 + h3 = h2, i.e., the thickness of the top glass plate plus the thickness of the bottom glass plate equals the air separation, then the effective dielectric constant is 2.09.

Thus, the embodiment of Figure 3 provides a dielectric plate made out of two plates separated using spacers to form air gap in between the two plates. Each of the plate may be made of glass, such as Vycor glass. Additionally, the spacers may also be made of Vycor glass. A ground plate may be formed on one glass, while the conductive line of radiating patch may be formed on the other glass plate.

Thus, as can be understood, according to one aspect, a radiating device is provided, comprising: a dielectric plate; a conductive ground plane formed on bottom surface of the dielectric plate; and a radiating element formed on top surface of the dielectric plate; wherein the dielectric plate comprises a plate of glass and a plate of foam.

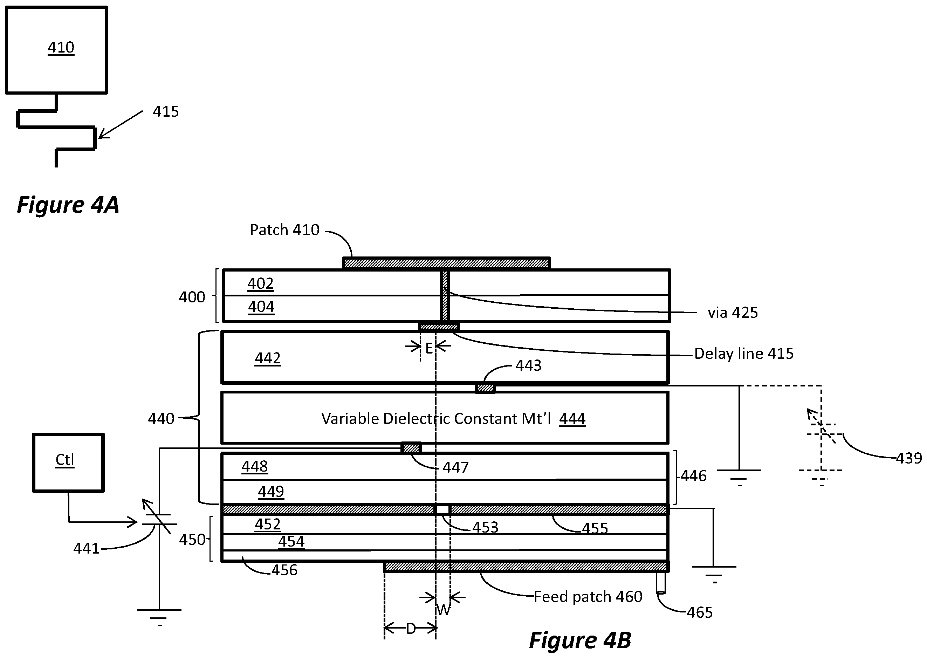

An example of a radiating device made using the innovative dielectric sandwich is shown in Figures 4A-4B. In United States Patent Application No. 15/654,643, Applicant disclosed a multi-layered software defined antenna which utilizes an array of radiating devices similar to that of Figures 4A-4B, thus only relevant parts relating to one of the radiating elements will be repeated herein. Figure 4B is a cross-section of the device shown in top view in Figure 4A, which is one example showing a multi-layered software defined antenna constructed using the dielectric sandwich disclosed herein.

The radiating patch is indicated as patch 410 and the delay line is indicated as conductive line 415. The radiating patch is formed on a top dielectric spacer 400 is generally in the form of a dielectric (insulating) plate or a dielectric sheet, but in this embodiment is made of a dielectric sandwich consisting of glass plate 402 and foam plate 404, e.g., Rohacell. The radiating patch 410 is formed on the top surface of the glass by, e.g., adhering a conductive film, sputtering, printing, etc. At the patch location, a via 425 is formed in the glass 402 and foam 404, and a conductor is passed through the via and is connected to the back surface of the patch 410. A delay line 415 is formed on the bottom surface of foam plate 404 (or on top surface of upper binder 442), and is connected physically and electrically to conductor in via 425. That is, there is a continuous DC electrical connection from the delay line 415 to radiating patch 410, through contact in via 425. As shown in Figure 4A, the delay line 415 is a meandering conductive line and may take on any shape so as to have sufficient length to generate the desired delay, thereby causing the desired phase shift in the RF signal.

The delay in the delay line 415 is controlled by the variable dielectric constant (VDC) plate 440 having variable dielectric constant material 444. While any manner for constructing the VDC plate 440 may be suitable for use with the embodiments of the antenna, as a shorthand in the specific embodiments the VDC plate 440 is shown consisting of upper binder 442, (e.g., glass, PET, etc.) variable dielectric constant material 444 (e.g., twisted nematic liquid crystal layer), and bottom binder 446. In other embodiments one or both of the binder layers 442 and 444 may be omitted. Alternatively, adhesive such as epoxy or glass beads may be used instead of the binder layers 442 and/or 444. Also, as illustrated in Figure 4B, one or both of the binders may be constructed as a sandwich according to the embodiments disclosed herein. As an example, bottom binder 446 is shown as a two layer sandwich having a foam plate 448 and a glass plate 449.

In some embodiments, e.g., when using twisted nematic liquid crystal layer, the VDC plate 440 also includes an alignment layer that may be deposited and/or glued onto the bottom of the upper binder 442. The alignment layer may be a thin layer of material, such as polyimide-based PVA, that is being rubbed or cured with UV radiation in order to align the molecules of the LC at the edges of confining substrates.

The effective dielectric constant of VDC plate 440 can be controlled by applying DC potential across the VDC plate 440. For that purpose, electrodes are formed and are connected to controllable voltage potential. There are various arrangements to form the electrodes, and several examples will be shown in the disclosed embodiments. In the arrangement shown in Figure 4B, two electrodes 443 and 447 and provided - one on the bottom surface of the upper binder 442 and one on the upper surface of the bottom binder 446. As one example, electrode 447 is shown connected to variable voltage potential 441, while electrode 443 is connected to ground. As one alternative, shown in broken line, electrode 443 may also be connected to a variable potential 439.

Thus, by changing the output voltage of variable potential 441 and/or variable potential 439, one can change the dielectric constant of the VDC material in the vicinity of the electrodes 443 and 447, and thereby change the RF signal traveling over delay line 415. Changing the output voltage of variable potential 441 and/or variable potential 439 can be done using a controller, Ctl, running software that causes the controller to output the appropriate control signal to set the appropriate output voltage of variable potential 441 and/or variable potential 439. Similarly, a conventional controller can be used to provide the control and common signals to control the characteristics of the antenna. Thus, the antenna's performance and characteristics can be controlled using software - hence software controlled antenna.

At this point it should be clarified that in the subject description the use of the term ground refers to both the generally acceptable ground potential, i.e., earth potential, and also to a common or reference potential, which may be a set potential or a floating potential. For example, conventional LCD display controllers output two signals per pixel, one of which is referred to as the ground or common signal. Similarly, while in the drawings the symbol for ground is used, it is used as shorthand to signify either an earth or a common potential, interchangeably. Thus, whenever the term ground is used herein, the term common or reference potential, which may be set or floating potential, is included therein.

In transmission mode the RF signal is applied to the feed patch 460 via connector 465 (e.g., a coaxial cable connector). As shown in Figure 4B, there is no electrical DC connection between the feed patch 460 and the delay line 415. However, in disclosed embodiments the layers are designed such that an RF short is provided between the feed patch 460 and delay line 415. As illustrated in Figure 4B, a back plane conductive ground (or common) 455 is formed on the top surface of backplane insulator (or dielectric) 450 or the bottom surface of bottom binder 446. The back plane conductive ground 455 is generally a layer of conductor covering the entire area of the antenna array. At each RF feed location a window (DC break) 453 is provided in the back plane conductive ground 455. The RF signal travels from the feed patch 460, via the window 453, and is coupled to the delay line 415. The reverse happens during reception. Thus, a DC open and an RF short are formed between delay line 415 and feed patch 460. The backplane insulator 450 can also be constructed according to embodiments disclosed herein, which in this example includes glass plate 452, foam plate 454, and glass plate 456.

Thus, as can be understood, according to one aspect, a radiating device is provided, comprising: a dielectric plate; a radiating element formed on top surface of the dielectric plate; a dielectric back-plate; a conductive ground plane formed on bottom surface of the dielectric back-plate; a variable dielectric constant material sandwiched between the dielectric plate and the dielectric back-plate; and wherein at least one of the dielectric plate and dielectric back-plate comprises a plate of glass and a plate of foam.

As illustrated so far, the embodiments disclosed herein can be used for radiating elements, such as antennas and antenna arrays. However, according to aspects of the invention, electronic devices or components can also be provided, which have variable electrical characteristics or operation based on potential applied to a variable-dielectric constant sector associated with the device and incorporate the low-cost dielectric sandwich. According to aspects of the invention, the electronic devices or component may include bends, power splitters, filters, ports, phase shifters, frequency shifters, attenuators, couplers, capacitors, inductors, diplexers, hybrids of beam forming networks, and may also include radiating elements in addition to the electronic devices. Notably, several devices can be formed on the same dielectric sandwich, just like was done in the prior art using Rogers^{®} or PCP.

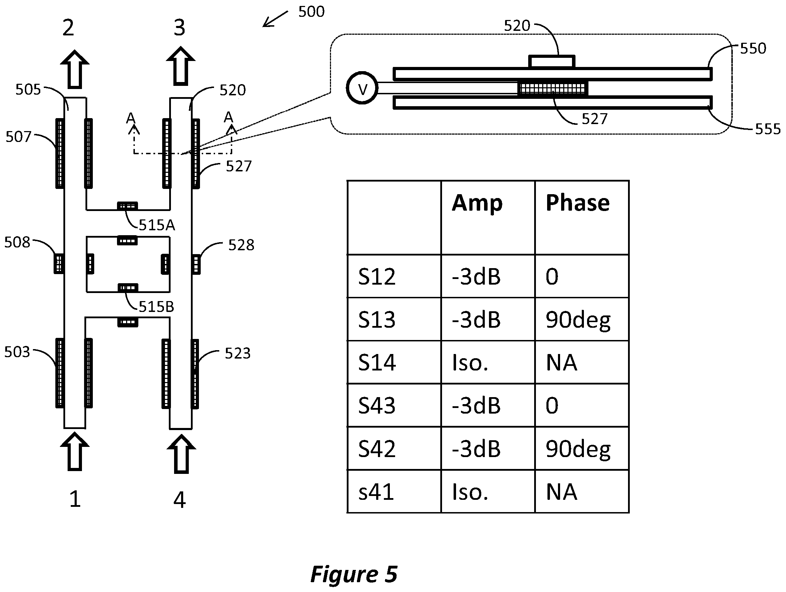

According to disclosed aspects, the electronic devices disclosed in Applicant's U.S. Patent Application, Ser. No. can be modified using the sandwich dielectric plate, to thereby provide the same performance, at a much lower cost. Figure 5 illustrates an embodiment of a four-ports hybrid coupler 500. Without any VDC's the signal input at port 1 splits into output to port 2 without phase change and into port 3 at 90 degrees phase change. Similarly, a signal input to port 4 splits into output to port 3 without phase change and into port 2 at 90 degrees phase change. This is captured by the table shown in Figure 5. However, in the embodiment of Figure 5 several optional placement for VDC's are shown, all or some of which may be implemented, depending on the desired control over the operation of the hybrid coupler 500.

For example, VDC 503 is provided under the line of input port 1. By applying voltage potential to the electrodes of VDC 503, the phase of the input signal can be controlled. Consequently, the phase at both output ports 2 and 3 would be varied together based on the phase change caused by the voltage potential at VDC 503. This means that the phase at output 2 can be different from the phase of the input signal at input port 1. On the other hand, the phase at output 2 can be changed independently by voltage potential at VDC 507. Consequently, the phase at output port 3 would remain 90° from the input at input port 1, but the phase at output port 2 would be different from zero, depending on the voltage potential applied to VDC 507. Additionally, a voltage potential can be applied to the electrodes of VDC 527 to vary the phase at output port 3 independent of the output at port 2. Thus, the output at port 2 can remain at the same phase as the input at port 1, but the output at port 3 can be modified from 90° with respect to the input at port 1. The same effect can be applied to the input of input port 4 by applying voltage potential to VDC's 523, 507 and 527. Moreover, normally an input signal at port 1 would be split at equal energies between output ports 2 and 3. However, by controlling the voltage potential at VDCs 508, 528, 515A and 515B, the amount of energy delivered to each output port can be changed, thus the amplitude of the output at each port can be controlled.

The cross-section structure of the device shown in Figure 5 can be seen in the callout of Figure 5. Element 527 is the variable dielectric constant material, that receive potential from power supplier V. The conductive line 520 is formed on top of a dielectric plate 550, that may be made according to any of the embodiments disclosed herein. For example, it may be made of a sandwich of glass plate and foam plate. The same goes for the back-plate 555, it also may be made according to any of the embodiments disclosed herein. For example, it may be made of a sandwich of glass plate and foam plate.

Thus, as can be understood, according to one aspect, an electronic device is provided, comprising: a back-plate; a dielectric plate; a variable dielectric constant material sandwiched between the back-plate and the dielectric plate; electrodes configured for applying electrical potential to the variable dielectric constant material; and a conductive line formed on top of the dielectric plate; wherein at least one of the dielectric plate and the back-plate comprises a plate of glass and a plate of foam.

Figure 6 illustrates a variant embodiment for an RF transmission conduit, which may be radiating, e.g., a non-radiating transmission line leading to a radiating patch. In the embodiment of Figure 6, the dielectric sandwich 200 is made up of two materials: a top layer of PET (Polyethylene terephthalate) 607 having high dielectric constant, a plate of material having dielectric constant close to that of air, for example a structural foam 604 that is mostly air, like, e.g., Rohacell, and a bottom layer of PET 608. The ratio of the thicknesses of the two PET layers and the foam plate, (h1+h3)/h2, is calculated to achieve the desired effective dielectric constant. For example, in the example of Figure 6, a PET layer having dielectric constant of about 4.0 at 3GHz is used. Depending on the formula used for fabrication of the PET, it may have a somewhat different dielectric constant, but it is within the range of 3.8-4.4.

In the example of Figure 2, a conductive line or patch 610 is fabricated on the top surface of PET 607. A conductive ground plane 605 is fabricated on the bottom surface of PET 608. Then the PET payers are adhered to the foam core 604. This makes it very easy to fabricate, since the conductive line 610 and conductive ground plane 605 are very easy to fabricate over PET, using various techniques, such as printing, sputtering, plating, etc. Moreover, the conductive circuitry 610 and 605 can be easily fabricated over the PET using reel-to-reel methods, which is fast and economical.

As with all RF antennas, reception and transmission are symmetrical, such that a description of one equally applies to the other. In this description it may be easier to explain transmission, but reception would be the same, just in the opposite direction.

It should be understood that processes and techniques described herein are not inherently related to any particular apparatus and may be implemented by any suitable combination of components. Further, various types of general purpose devices may be used in accordance with the teachings described herein. The present invention has been described in relation to particular examples, which are intended in all respects to be illustrative rather than restrictive.

Moreover, other implementations of the invention will be apparent to those skilled in the art from consideration of the specification and practice of the invention disclosed herein. It is intended that the specification and examples be considered as exemplary only, with a true scope of the invention being indicated by the following claims.

## Claims

1. An antenna, comprising:
a dielectric plate (400);
at least one radiating patch (410) provided on top of the dielectric plate (400);
at least one delay line (415) provided below the dielectric plate (400);
wherein the dielectric plate (400) comprises at least one first high-dielectric constant layer (402) having a dielectric constant of 3.8-4.4 and one first foam plate (404) contiguous with each other,
a variable dielectric constant layer (444) provided below the delay line (415);
a ground plane (455) provided below the variable dielectric constant layer (444);
a bottom insulating plate (450) provided below the ground plane (455); and,
a feed line (460) provided below the bottom insulating plate (450);
wherein the bottom insulating plate (450) comprises a second foam plate (454) sandwiched between two glass plates (452; 456) or a second foam plate (454) sandwiched between two polyethylene terephthalate plates (452; 456).

2. The antenna of Claim 1, wherein the at least one first high-dielectric constant layer (402) is formed of glass.

3. The antenna of Claim 1, wherein the at least one first high-dielectric constant layer (402) is formed of polyethylene terephthalate.

4. The antenna of Claim 1, wherein the first foam plate (404) is formed to have a dielectric constant of 1.0 to 1.1.

5. The antenna of Claim 1, wherein the dielectric plate (400) comprises a top polyethylene terephthalate layer and a bottom polyethylene terephthalate layer, wherein the first foam plate (404) is sandwiched between the top polyethylene terephthalate layer and the bottom polyethylene terephthalate layer.

6. The antenna of claim 1, wherein the variable dielectric constant layer (440) comprises a variable dielectric constant material (444) and at least one of an upper binder (442) and a bottom binder (446).

7. The antenna of claim 6, wherein one or both of the upper binder (442) and the bottom binder (446) comprises at least one second high-dielectric constant layer (449) having a dielectric constant of 3.8-4.4 and one third foam plate (448).

8. The antenna of claim 1, further comprising conductive electrodes (443) abutting the variable dielectric constant material (444).

9. The antenna of claim 1, further comprising at least one conductive via (425) connecting each one of the delay lines (415) to a corresponding radiating patch (410).

10. The antenna of claim 1, wherein the ground plane (455) comprises at least one window (453), each window being aligned below a corresponding one of the radiating patches (410).

## Patentansprüche

1. Antenne, umfassend:
eine dielektrische Platte (400);
mindestens ein strahlendes Patch (410), das oben auf der dielektrischen Platte (400) vorgesehen ist;
mindestens eine Verzögerungsleitung (415), die unterhalb der dielektrischen Platte (400) vorgesehen ist;
wobei die dielektrische Platte (400) mindestens eine erste Schicht (402) mit hoher Dielektrizitätskonstante mit einer Dielektrizitätskonstante von 3,8-4,4 und eine erste Schaumstoffplatte (404) umfasst, die aneinander angrenzend sind,
eine Schicht mit variabler Dielektrizitätskonstante (444), die unterhalb der Verzögerungsleitung (415) vorgesehen ist;
eine Grundplatte (455), die unter der Schicht mit variabler dielektrischer Konstante (444) vorgesehen ist;
eine untere isolierende Platte (450), die unterhalb der Grundplatte (455) vorgesehen ist; und,
eine Zuleitung (460), die unterhalb der unteren Isolierplatte (450) vorgesehen ist;
wobei die untere Isolierplatte (450) eine zwischen zwei Glasplatten (452; 456) in die Mitte genommene zweite Schaumstoffplatte (454) oder eine zwischen zwei
Polyethylenterephthalat-Platten (452; 456) in die Mitte genommene zweite Schaumstoffplatte (454) umfasst.

2. Antenne nach Anspruch 1, wobei die mindestens eine erste Schicht (402) mit hoher Dielektrizitätskonstante aus Glas gebildet ist.

3. Antenne nach Anspruch 1, wobei die mindestens eine erste Schicht mit hoher Dielektrizitätskonstante (402) aus Polyethylenterephthalat gebildet ist.

4. Antenne nach Anspruch 1, wobei die erste Schaumstoffplatte (404) so ausgebildet ist, dass sie eine Dielektrizitätskonstante von 1,0 bis 1,1 aufweist.

5. Antenne nach Anspruch 1, wobei die dielektrische Platte (400) eine obere Polyethylenterephthalat-Schicht und eine untere Polyethylenterephthalat-Schicht umfasst, wobei die erste Schaumstoffplatte (404) zwischen der oberen Polyethylenterephthalat-Schicht und der unteren Polyethylenterephthalat-Schicht in die Mitte genommen wird.

6. Antenne nach Anspruch 1, wobei die Schicht (440) mit variabler Dielektrizitätskonstante ein Material (444) mit variabler Dielektrizitätskonstante und mindestens eines von einem oberen Bindemittel (442) und einem unteren Bindemittel (446) umfasst.

7. Antenne nach Anspruch 6, wobei das obere Bindemittel (442) und/oder das untere Bindemittel (446) mindestens eine zweite Schicht mit hoher Dielektrizitätskonstante (449) mit einer Dielektrizitätskonstante von 3,8-4,4 und eine dritte Schaumstoffplatte (448) umfasst.

8. Antenne nach Anspruch 1, ferner umfassend leitende Elektroden (443), die an das Material mit variabler Dielektrizitätskonstante (444) anliegen.

9. Antenne nach Anspruch 1, ferner umfassend mindestens ein leitendes Durchgangsloch (425), das jede der Verzögerungsleitungen (415) mit einem entsprechenden strahlenden Patch (410) verbindet.

10. Antenne nach Anspruch 1, wobei die Grundplatte (455) mindestens ein Fenster (453) umfasst, wobei jedes Fenster unter einem entsprechenden der strahlenden Patches (410) ausgerichtet ist.

## Revendications

1. Antenne, comprenant :
une plaque diélectrique (400) ;
au moins une plaque rayonnante (410) disposée par-dessus la plaque diélectrique (400) ;
au moins une ligne à retard (415) disposée sous la plaque diélectrique (400) ;
dans laquelle la plaque diélectrique (400) comprend au moins une première couche à constante diélectrique élevée (402) ayant une constante diélectrique de 3,8 à 4,4 et une première plaque de mousse (404) contiguës l'une à l'autre,
une couche à constante diélectrique variable (444) disposée sous la ligne à retard (415) ;
un plan de masse (455) disposé sous la couche à constante diélectrique variable (444) ;
une plaque isolante inférieure (450) disposée sous le plan de masse (455) ; et,
une ligne d'alimentation (460) disposée sous la plaque isolante inférieure (450) ;
dans laquelle la plaque isolante inférieure (450) comprend une deuxième plaque de mousse (454) prise en sandwich entre deux plaques de verre (452 ; 456) ou une deuxième plaque de mousse (454) prise en sandwich entre deux plaques de poly(téréphtalate d'éthylène) (452 ; 456).

2. Antenne selon la revendication 1, dans laquelle l'au moins une première couche à constante diélectrique élevée (402) est formée de verre.

3. Antenne selon la revendication 1, dans laquelle l'au moins une première couche à constante diélectrique élevée (402) est formée de poly(téréphtalate d'éthylène).

4. Antenne selon la revendication 1, dans laquelle la première plaque de mousse (404) est formée pour avoir une constante diélectrique de 1,0 à 1,1.

5. Antenne selon la revendication 1, dans laquelle la plaque diélectrique (400) comprend une couche supérieure de poly(téréphtalate d'éthylène) et une couche inférieure de poly(téréphtalate d'éthylène), dans laquelle la première plaque de mousse (404) est prise en sandwich entre la couche supérieure de poly(téréphtalate d'éthylène) et la couche inférieure de poly(téréphtalate d'éthylène).

6. Antenne selon la revendication 1, dans laquelle la couche à constante diélectrique variable (440) comprend un matériau à constante diélectrique variable (444) et au moins un liant supérieur (442) et un liant inférieur (446).

7. Antenne selon la revendication 6, dans laquelle l'un ou les deux du liant supérieur (442) et du liant inférieur (446) comprend ou comprennent au moins une seconde couche à constante diélectrique élevée (449) ayant une constante diélectrique de 3,8 à 4,4 et une troisième plaque de mousse (448).

8. Antenne selon la revendication 1, comprenant en outre des électrodes conductrices (443) en butée avec le matériau à constante diélectrique variable (444).

9. Antenne selon la revendication 1, comprenant en outre au moins un via conducteur (425) connectant chacune des lignes à retard (415) à une plaque rayonnante (410) correspondante.

10. Antenne selon la revendication 1, dans laquelle le plan de masse (455) comprend au moins une fenêtre (453), chaque fenêtre étant alignée sous une plaque correspondante des plaques rayonnantes (410).
